# EUROPEAN PATENT APPLICATION

(11) **EP 0 817 549 A2**
(43) Date of publication of application: **07.01.1998**
(21) Application number: 97110585.3
(22) Date of filing: 27.06.1997
(51) Int. Cl.: H05K 3/18, H05K 3/10, H05K 3/46

(54) **Circuit board and method of producing the same**

(30) Priority: 28.06.1996 JP 169673/96; 05.08.1996 JP 206186/96
(71) Applicant: NGK Spark Plug Co. Ltd., Nagoya-shi Aichi-ken 467 (JP)
(72) Inventor: Murata, Haruhiko, Mizuho-ku, Nagaoya-shi, Aichi 467 (JP); Hasegawa, Katsuhiko, Mizuho-ku, Nagaoya-shi, Aichi 467 (JP); Akita, Naoyuki, Mizuho-ku, Nagaoya-shi, Aichi 467 (JP); Matsuura, Yasunari, Mizuho-ku, Nagaoya-shi, Aichi 467 (JP); Kimura, Yukihiro, Mizuho-ku, Nagaoya-shi, Aichi 467 (JP)
(74) Representative: Grünecker, Kinkeldey, Stockmair & Schwanhäusser Anwaltssozietät

(57) **Abstract**

There is provided a circuit board consisting of a substrate or lower insulation layer, a side insulation layer and a conductor wiring layer, wherein catalytic nuclei for plating are provided to an interface between a bottom surface of the conductor wiring layer and an upper surface of the lower insulation layer and to an interface between a side surface of the conductor wiring layer and a side surface of the side insulation layer. There is also provided a multi-layered circuit board including an insulation interlayer formed with a via for electrical connection between conductor wiring layers on the opposite sides of the insulation interlayer, wherein catalytic nuclei for plating are provided to an interface between a side surface of the via and the insulation interlayer. A method of producing such a circuit board is also provided.

## Description

### BACKGROUND OF THE INVENTION

### 1. Field of the Invention

The present invention relates to a circuit board such as a plastic circuit board, a printed circuit board or the like for forming thereon or therein various electronic circuits or for mounting thereon various electronic parts or devices. The present invention further relates to a method of making such a circuit board.

### 2. Description of the Related Art

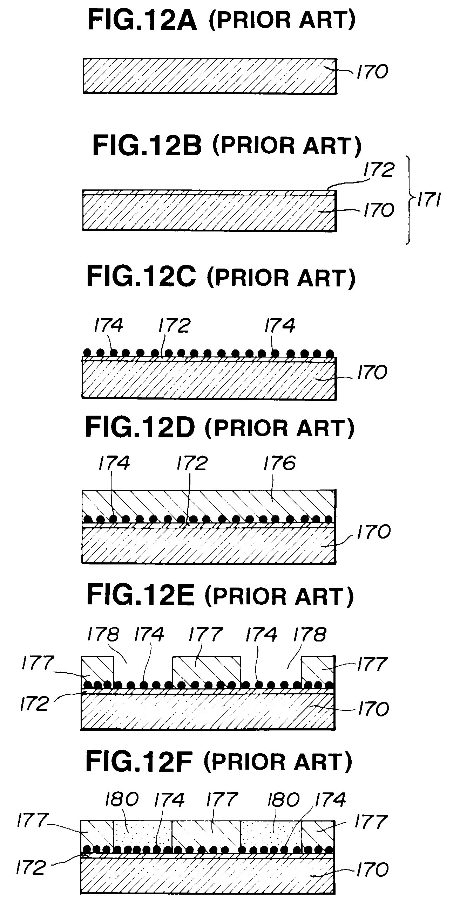

A subtractive process, semi-additive process and full-additive process are generally known as a process for forming a conductor wiring on and in a circuit board substrate. Of those processes, the subtractive process and full-additive process include a step of once forming a conductor layer on an entire surface of the substrate and then removing by etching the conductor layer except for a portion that constitutes a conductor wiring, so due to an over etching phenomenon a wiring line becomes narrower at the upper end and wider at the lower end thereof. Thus, those processes are not suited for forming a fine wiring pattern. For this reason, for forming a fine wiring pattern, it is suited a method of forming a side insulation layer at the entire surface of the substrate except for a portion at which the conductor wiring is formed and then forming a conductor wiring line in a groove whose side surfaces are defined by the side insulation layer and whose bottom surface is defined by a lower insulation layer. To the same end, it has heretofore been used a full-additive process such as one shown in Figs. 12A to 12F.

Referring to Figs. 12A to 12F, an adhesive substance containing synthetic rubber of a diene group is applied to an upper surface of a substrate 170 shown in Fig. 12A to form an adhesive substance layer 172 as shown in Fig. 12B, whereby to constitute a lower insulation layer 171 consisting of the substrate 170 and the adhesive substance layer 172. Then, the surface of the adhesive substance layer 172 is roughed and thereafter, as shown in Fig. 12C, catalytic Pd (palladium) nuclei 174 for plating are attached to the roughed surface to activate the adhesive substance layer 172. Then, photosensitive resin is applied to the upper surface of the adhesive substance layer 172 provided with the catalytic nuclei 174 to form an insulation layer 176 covering the entire upper surface. In order to obtain a predetermined wiring pattern, ultra violet rays are irradiated to the insulation layer 176 under a masked condition for thereby carrying out exposure thereof. Thus, only the unexposed portion, for example, is dissolved and removed (i.e., developed) by solvent cleaning to form a side insulation layer 177 and groves 178 between adjacent two layer sections of the side insulation layer 177. The substrate 170 is immersed in its entirety into a plating bath to electroless plate the same, whereby conductor wiring layers 180 originating from the catalytic nuclei 174 can be formed within the grooves 178.

However, since the above described method utilizes an adhesive containing synthetic rubber, it encounters various problems, e.g., the resistance to heat is low and the adhesive strength in adhesion between the substrate 170 and the conductor wiring layers 180 at high temperature is small.

Thus, as disclosed in Japanese patent provisional publication No. 61-276875, it has been proposed a method of making a circuit board by electroless plating and by the use of an adhesive substance layer having dispersed therein heat resistant, fine resin powder having been subjected to a particular treatment.

Further, in order to improve the insulation property of the side insulation layer interposed between adjacent two of the conductor wiring layers, it has been proposed to carry out electroless plating under a condition that reducing ions are removed partially from the catalytic nuclei attached to the adhesive substance layer on the substrate as for example disclosed in Japanese patent provisional publication No. 6-69632.

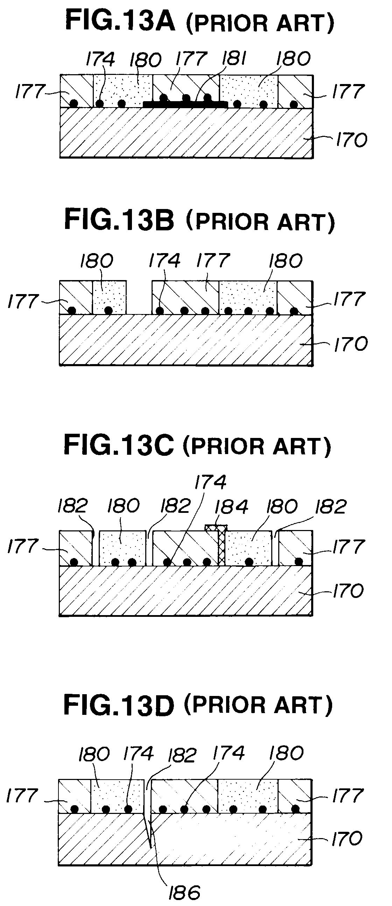

In the above described conventional full additive process, the catalytic nuclei are first attached to the entire upper surface of the substrate 170 and thereafter the side insulation layer 177 are formed on the substrate, so this process encounters the following problems.
(1) Since the catalytic nuclei 174 for plating are provided even to or exist even at the lower end portion of the layer section of the side insulation layer 177 located between two of the conductor wiring layers 180, there is a possibility that, as shown in Fig. 13A, migration 181 is caused between the conductor wiring layers 180 to cause a short circuit.
(2) When the side insulation layer 177 is formed by solvent cleaning (development) of the insulation layer 176, there is a possibility that, as shown in Fig. 13B, the portion of the catalytic nuclei 174 for plating, which is attached to the upper surface portion of the substrate 170 exposed to the inside of the groove 178, are partially removed. Thus, such an exposed upper surface portion of the substrate 170 is not plated when processed by electroless plating, so lack of the conductor wiring layers 180 may possibly occur to cause a defective wiring.
(3) Since no catalytic nuclei are provided between the side surface of the side insulation layer 177 and the corresponding side surface of the conductor wiring layer 180, their matching side surfaces lack adherence and therefore a gap or space 182 is liable to be caused between them. As shown in Fig. 13C, such a gap or space 182 is causative of a stain 184 due to the plating solution remaining therein or causative of lowering or deteriorating the insulation property.

Further, when such a circuit board is subjected to a temperature cycling test (MIL-STD-883C Method 1010) that repeats a predetermined number of cycles of heating and cooling, there is a possibility that, as for example shown in Fig. 13D, a crack 186 that starts from the above described gap 182 and is extend inside of the substrate 170 is caused.

### SUMMARY OF THE INVENTION

In order to solve the above described problem (1), it is required that no catalytic nuclei 174 exist under the side insulation layer 177.

Further, in order to solve the above described problems (2) and (3), it is required that the catalytic nuclei 174 for plating exist at the interface between the side surface of the side insulation layer 177 and the side surface of the conductor wiring layer 180.

From these points of view, the following matters need to be fulfilled to solve the above described problems.
① Attachment of the catalytic nuclei 174 for plating to the upper surface of the substrate 170 should be carried out after the side insulation layer 177 and the grooves 178 have been formed.
   However, if the above described matter ① is fulfilled, the catalytic nuclei 174 will be attached to the upper surface and the side surfaces of the side insulation layer 177 and the upper surface portion of the substrate 170 exposed to the groove 178, so if all those surfaces are electroless plated a plated layer will be deposited also on the upper surface and the side surface of the side insulation layer, thus causing another problem of a short circuit between the conductor wiring layers 180. Thus, the following matter ② needs to be fulfilled.
② When a conductor wiring layer 180 is formed by electroless plating, it is required that the catalytic nuclei 174 do not exist on the upper surface of the side insulation layer 177 or after the conductor wiring layer 180 is provided, the plated layer and the catalytic nuclei do not exist on the upper surface of the side insulation layer.

In order to satisfy the above two requirements, a new and improved technology or process related to a full additive process and further to a process of first forming on an upper surface of a lower insulation layer a side insulation layer capable of forming a groove of a predetermined pattern and then forming a conductor wiring layer within the groove, has been invented by the inventors through their diligent and earnest investigation and research.

According to a first aspect of the present invention, there is provided a circuit board which comprises a lower insulation layer, a side insulation layer formed on an upper surface of the lower insulation layer and having a pair of layer sections, a conductor wiring layer formed on the upper surface of the lower insulation layer and having opposite side surfaces in contact with the layer sections of the side insulation layer, respectively, wherein catalytic nuclei for plating are provided to an interface between a bottom surface of the conductor wiring layer and the upper surface of the lower insulation layer and to an interface between each of the side surfaces of the conductor wiring layer and a corresponding side surface of each of the layer sections of the side insulation layer.

Accordingly, this invention enables the conductor wiring layer to be firmly adhered to the lower insulation layer and the side insulation layer and to prevent occurrence of stain, deterioration of the insulation property and furthermore occurence of a crack or cracks in the lower insulation layer.

In the meantime, the above described lower insulation layer is herein used to encompass a substrate or base insulation layer and in addition an insulation interlayer for insulation between upper and lower conductor wiring layers provided according to a build-up technology.

Further, while in this invention the catalytic nuclei for plating are provided to the interface between the bottom surface of the conductor wiring layer and the upper surface of the lower insulation layer and to the interface between each of the side surfaces of the conductor wiring layers and the corresponding side surface of each of the layer sections of the side insulation layer, they are not provided to the interface between the lower insulation layer and the side insulation layer. By this, there never occurs migration due to the catalytic nuclei between the lower insulation layer and the side insulation layer and therefore there never occurs a short circuit.

According to another aspect of the present invention, the lower insulation layer has a via at a location just under the conductor wiring layer, and catalytic nuclei for plating are provided to an interface between a side surface of the via and the lower insulation layer.

By forming the via in the lower insulation layer (i.e., insulation interlayer), a circuit board of a so-called build-up structure can be obtained. In this connection, since there exist catalytic nuclei at the interface between the side surface of the via and the lower insulation layer, the via can be firmly adhered to the lower insulation layer.

In the meantime, for the above described catalytic nuclei for plating, it is desirable to use at least one of Pd, Au, Ag, Pt, Rh, In and Os.

Further, for the above described conductor wiring layer, it is desirable to use at least one of metal or alloy selected from the group of, for example, Cu, Ni (Ni-P, Ni-B, Ni-Cu-P, Ni-Co or the like Ni alloy being included), Co(Co-P, Co-B, Co-Ni-P, Co-Ni-B or the like Co alloy being included), Au, Ag, Pd, Sn(Sn-Pb, Pd-Pb-Sn or the like Sn alloy being included), Pt, Rh and Ru.

According to a further aspect of the present invention, there is provided a method of making a circuit board which comprises the steps of forming a side insulation layer having a pair of layer sections, on an upper surface of a lower insulation layer and forming a groove of a predetermined pattern defined by side surfaces of the layer sections of the side insulation layer and the upper surface of the lower insulation layer, attaching catalytic nuclei for plating to at least the side surfaces of the layer sections of the side insulation layer and a portion of the upper surface of the lower insulation layer exposed to the groove, and electroless plating inside of the groove and forming a conductor wiring layer within the groove.

By this, the catalytic nuclei can be attached to the side surfaces of the layer sections of the side insulation layer as well as the bottom surface of the groove, so the conductor wiring layer can be firmly adhered also to the side surfaces of the groove.

In the meantime, after the side insulation layer is formed to provide the grove and before the catalytic nuclei are attached to the inside of the grove , it is desirable to subject the groove to desmear treatment by using desmear solutions such as permanganic acid or chromic acid. By this, the adherence strength of the lower insulation layer and the conductor wiring layer can be improved or made larger.

According to a further aspect of the present invention, the above described step of forming the side insulation layer comprises a step of applying a photosensitive resin to the upper surface of the lower insulation layer and drying the same to form a photosensitive resin layer, and a step of subjecting the photosensitive resin layer to exposure and development to form the side insulation layer and the groove of the predetermined pattern.

By this, a groove of a predetermined pattern can be formed with accuracy.

In the meantime, the above described photosensitive resin can be made of epoxy resin, polyimide resin or the like.

Further, the above described step of forming the side insulation layer from photosensitive resin can be replaced by screen printing of acrylic resin or ABS resin.

Further, the above described step of forming the conductor wiring layer can be replaced by an electroless plating process including a first plating step by low speed electroless plating and s second plating step by high speed electroless plating.

The above described low speed electroless plating, though its deposition speed is low, can deposit a dense plated layer on the upper surface of the lower insulation layer and the side surfaces of the side insulation layer and accurately in accordance with the surface irregularities thereof, so by the present invention the lower insulation layer and the side insulation layer can be firmly adhered to each other without forming any vacant space therebetween.

On the other hand, by high speed electroless plating, a period of time necessary for forming the conductor wiring layer can be shortened and the man hour can be reduced.

According to a further aspect of the present invention, the method comprises, after the above described step of attaching the catalytic nuclei for plating, a step of removing an upper end portion of the side insulation layer by grinding.

By this, the catalytic nuclei attached to the upper end portion of the side insulation layer can be removed easily and assuredly.

According to a further aspect of the present invention, the above described step of forming the conductor wiring layer comprises a first plating step of carrying out the electroless plating until a plated layer of a predetermined thickness is obtained, a step of removing by grinding a portion of the plated layer deposited on an upper surface of the side insulation layer and further removing by grinding an upper end portion of the side insulation layer by grinding and a second plating step of thereafter electroless plating the inside of the groove once again and forming the conductor wiring layer.

By this, the catalytic nuclei attached to the upper surface of the side insulation layer can be removed easily and assuredly, and furthermore whether the upper end portion of the side insulation layer is removed or not by grinding or the like can be judged with ease by reference to whether the electroloss plated layer by the first plating remains or not.

In the meantime, the above described first plating step can be done by the above described low-speed electroless plating, while the second plating step can be done by the above described high-speed electroless plating. By this, the lower insulation layer and the side insulation layer can be adhered firmly while enabling to reduce the man hour for plating.

According to a further aspect of the present invention, the method further comprises, after the above described step of forming the side insulation layer, a step of forming a thin water repellent resin layer on an upper surface of the side insulation layer.

By this, attachment of the catalytic nuclei to the upper surface of the side insulation layer can be prevented by the thin water repellent resin layer.

Enumerated for the water repellent resin are for example silicon resin and fluororesin.

According to a further aspect of the present invention, the photosensitive resin forms at a surface portion thereof a thin water repellent resin layer when dried.

By this, a thin water repellent resin is formed on the upper surface of the side insulation layer automatically, thus making it possible to dispense with an additional step of applying water repellent resin and furthermore making it possible to form a thin water repellent layer only on the upper surface of the side insulation layer assuredly.

Enumerated for the water repellent resin are also silicon resin and fluororesin. The photosensitive resin can be for example silicon resin having at the end a functional group capable of polymerizing photosensitive epoxy resin.

According to a further aspect of the present invention, the above described step of forming the insulation layer comprises, before the exposure of the photosensitive resin layer or after the exposure but before the development of same, a step of applying an anion surface active agent to an upper surface of the side insulation layer.

By this, the Pb-Sn colloid which is charged negative and the anion surface active agent are caused to repel each other, thus making it possible that the catalytic nuclei are hardly attached to the upper surface of the side insulation layer.

According to a further aspect of the present invention, the method comprises, after the above described stop of forming the conductor wiring layer, a step of removing an upper end portion of the conductor wiring layer and an upper end portion of the side insulation layer by grinding and making the conductor wiring layer and the side insulation layer have a predetermined, uniform thickness.

By this, the conductor wiring layer and the side insulation layer can be uniform in height, thus not causing any surface irregularity which is defective in case another insulation layer and conductor wiring layer are formed thereon. So, such a circuit board can be produced with ease and be accurate in thickness while being excellent in the positional accuracy of the insulation layer and the conductor wiring layer.

According to a further aspect of the present invention, the conductor wiring layer comprises an electroless plated layer located on a bottom surface side thereof and an electroplated layer formed on the electroless plated layer.

The electroplated wiring layer is finer and more dense in the quality of material as compared with the electroless plated wiring layer and superior in the physical property (ductility, tensile strength, conductivity, etc.) to same, so the strength, conductivity and the like of the conductor wiring layer can be improved or made higher by the degree corresponding to the amount or percentage by which the conductor wiring layer is formed of the electroplated wiring layer.

When the conductor wiring layer is mainly constituted by an electroplated wiring layer, a crack or cracks are hardly caused in the conductor wiring layer or in the insulation layer.

According to a further aspect of the present invention, there is provided a method of making a circuit board which comprises the steps of forming a side insulation layer having a pair of layer sections, on an upper surface of a lower insulation layer and thereby forming a groove of a predetermined pattern defined by side surfaces of the layer sections of the side insulation layer and the upper surface of the lower insulation layer, attaching catalytic nuclei for plating to an upper surface of the side insulation layer, the side surfaces of the layer sections of the side insulation layer and a portion of the upper surface of the lower insulation layer exposed to the groove, electroless plating the upper surface of the side insulation layer and an inside of the groove and forming an electroless plated layer thereon, and electroplating the electroless plating layer and forming an electroplated layer thereon.

Accordingly, by this aspect, an electroplated layer which is a coating or film excellent in the physical properties can be formed with ease on the side insulation layer and within the groove with ease by connecting the electroless plated layer as an electrode (cathode), so it becomes possible to form a conductor wiring layer of excellent properties.

Further, in case the most of the conductor wring layer is formed by electroplating, e.g., in case the electroplated layer (for example, 10 µm) is made further thicker than the electroless plated layer (for example, 1 µm), there is obtained, in addition to an advantage that the physical properties of the conductor wiring layer of itself are improved, an advantage that a period of time for plating is shortened, control of plating solutions can be simplified, and the amount of electroless plating solutions containing harmful or noxious formalin to be used can be reduced. Furthermore, since the circuit board or work is not required to be immersed in electroless plating solutions of high alkaline (≧ PH 12) for long hours (several to several tens of hours), a larger number of materials can be used for plating resist.

In the meantime, the above described electroless plating layer and electroplated layer are formed over the entire surface of the circuit board or work including the groove and the upper surface of the side insulation layer, then removed except for a wiring pattern and formed into a conductor wiring layer for example consisting of an electroless plating layer and an electroplated layer as described above. That is, the conductor wiring layer is constituted by the portions of the electroless plated layer and the electroplated layer which are formed above the groove.

According to a further aspect of the present invention, the above described step of forming the side insulation layer comprises a step of applying a photosensitive resin to the upper surface of the lower insulation layer and drying the same to form a photosensitive resin layer thereon, and a step of subjecting the photosensitive resin layer to exposure and development to form the side insulation layer and the groove of the predetermined pattern.

By this, a groove of a predetermined pattern can be formed with accuracy.

According to a further aspect of the present invention, the method further comprises, after forming a conductor layer consisting of the electroless plated layer and the electroplated layer, a step of forming an etching resist layer on an upper surface portion of the conductor layer above the groove, and a step of thereafter carrying out etching and removing all of the conductor layer except for a portion thereof on which the etching resist layer is formed.

By this aspect, since the etching resist layer is formed above the groove, the conductor layer which is made of Cu or the like soft metal and thus has a difficulty in being removed by grinding or the like physical means, can be removed by etching with efficiency and assuredness except for the portion thereof on which the etching resist layer is formed. Accordingly, by thereafter removing the etching resist layer, the portion of the conductor layer remaining within the groove can be used as a conductor wiring layer.

According to a further aspect of the present invention, the step of forming the conductor wiring layer comprises a step of conducting the electroless plating to form a conductor layer of a predetermined thickness on an upper surface of the side insulation layer as well as the side surfaces of the layer sections of the side insulation layer and the upper surface portion of the lower insulation layer exposed to the groove, a step of forming an etching resist layer on an upper surface portion of the conductor layer above the groove, and a step of thereafter conducting etching and removing all of the conductor layer except for a portion thereof on which the etching resist layer is formed.

By this aspect the the conductor layer is formed by electroless plating, so it is not necessary to change the step, at the halfway thereof, to electroplating.

Further, since the etching resist layer is formed above the groove similarly to the above described aspect, the conductor layer which is made of Cu or the like soft metal and thus has a difficulty in being removed by grinding or the like physical means, can be removed by etching with efficiency and assuredness except for the portion thereof on which the etching resist layer is formed.

Accordingly, by thereafter removing the etching resist layer, the conductor layer remaining within the groove can be used as a conductor wiring layer.

In the meantime, in the above described aspects relating to the step of forming a conductor wiring layer by using an etching resist layer, a resist made of an organic compound such as epoxy resin can be used as a material for forming the etching resist layer. Further, in the step of removing the unnecessary conductor layer by etching, e.g., for removing a conductor layer made of Cu, chemical etching solutions having a strong or large etching power, such cupric chloride, ferric chloride or the like, can be used. By this, the catalytic nuclei existing at the lower end portion of the conductor, i.e., at the interface between the conductor layer and the upper surface of the side insulation layer can be removed assuredly, whereby the circuit board can be made free from deterioration of insulation. Further, after etching has been carried out, the etching resist can be removed by such a method of exfoliating or dissolving the etching resist layer by a solution such as methylene chloride, xylene, acetone or the like.

According to a further aspect of the present invention, the step of forming the etching resist layer comprises a step of forming an etching resist film on an upper surface of the conductor layer, and a step of removing by grinding the etching resist film until at least a portion of the side conductor layer located above the side insulation layer is exposed, except for a portion thereof located above the groove.

In this aspect, the etching resist layer is once formed on the upper surface of the conductor layer. In the meantime, the conductor layer is formed with, at the portion thereof under which the groove is positioned, a recess which is formed after the shape of the recess. Due to this the etching resist layer becomes thicker at the portion corresponding in position to the recess. Thereafter, by removing the etching resist film by grinding until the conductor layer on the side insulation layer is exposed, the etching resist film can be removed except for the portion thereof corresponding in position to the recess, i.e., the portion thereof located above the groove. That is, by once forming the etching resist layer and thereafter removing a suitable thickness thereof by grinding, the etching resist layer can be formed in the place above the groove without causing any movement out of place and without requiring a difficult work for positioning or alignment and the like.

In the meantime, the etching resist layer can be formed by a process of printing etching resist ink or a process of laminating an etching resist dry film.

According to a further aspect of the present invention, the above described step of forming the etching resist layer comprises forming an etching resist film on the conductor layer, and removing by resin etching the etching resist film until at least a portion of the conductor layer located above the side insulation layer is exposed, except for a portion thereof located above the groove.

In this aspect, the etching resist film is once formed on the upper surface of the conductor layer similarly to the above described aspect. In the meantime, the conductor layer is formed with, at the portion thereof under which the groove is positioned. a recess which is formed after the shape of the recess. Due to this, the etching resist layer becomes thicker at the portion corresponding in position to the recess. Thereafter, by removing the etching resist film by using a resin etching solution such as a potassium chromate or potassium permanganate solution until the conductor layer on the side insulation layer is exposed, the etching resist film can he removed except for the thick portion thereof, i.e., the portion thereof located above the groove. That is, by once forming the etching resist layer and thereafter removing a suitable thickness thereof by resin etching, the etching resist layer can be formed in the place above the groove without causing any movement out of place and without requiring a difficult work for positioning or alignment and the like.

In the meantime, it is desirable that the etching resist layer is formed by applying the etching resist ink on the conductor layer by squeeze. This is because the ink can be applied into the recess with pressure while being capable of being expanded relatively thin at the place other than the recess.

According to a further aspect of the present invention, the above described step of forming the etching resist layer comprises printing an etching resist film on the upper surface portion of the conductor layer above the groove and curing the same.

In this aspect, since the etching resist layer is printed on the upper surface of the conductor layer and in the place above the groove and then cured, a relatively thick etching resist can be formed on the upper surface of the conductor layer and in the place above the groove while the portion of the conductor layer which is covered by the etching resist layer can be assuredly made to remain unremoved at the time of etching. Further, by a change or modification of the mask pattern, the shape of the etching resist layer can be changed or modified with ease, so an etching resist layer can have a suitable shape. Further, since the etching resist layer is formed only at the necessitated place, the used or consumed amount of etching resist can be reduced. Furthermore, since it is not necessary to remove an unnecessary etching resist film, the process can be simplified.

According to a further aspect of the present invention, the above described step of forming said etching resist layer comprises a step of applying a photosensitive etching resist film to the upper surface of the conductor layer, and a step of removing the photosensitive etching resist film except for a portion thereof above the groove by exposure and development and making at least a portion of the conductor layer located above the side insulation layer be exposed.

By this aspect, by a change or modification of the mask pattern the shape of the etching resist layer can be changed or modified with ease.

According to a further aspect of the present invention, the method comprises, after the above described step of removing the etching resist layer, a step of grinding at least an upper end portion of the conductor layer which remains unremoved at the step of removing the conductor layer and making surface arrangement thereof.

There occurs such a case in which the upper end portions of the unremoved conductor layer have horn-like or moustache like corners or those upper end portions protrude upward from the side insulation layer.

In this aspect, since such corners or protruded upper end portions can be removed by grinding, it becomes possible to prevent occurrence of such a case in which the insulation distance between the conductor wiring layers becomes shorter than desired, or when another insulation layer and conductor layers are further formed on such a conductor layer having such pointed corners or protruded upper end portions, the insulation layer is held on same while allowing the horn-like or moustache-like corners or protruded upper end portions to bite thereinto and make the insulation distance between the upper and lower conductor layers become shorter than desired. Further, it becomes possible to prevent such a case in which the corner portions are broken to be removed and serve as conductor chips that cause a short circuit between other wires or circuits.

According to a further aspect of the present invention, the above described step of making the surface arrangement further comprises a step of grinding the upper surface of the side insulation layer and making surface arrangement of same.

By this aspect, in case the difference in height between the unremoved conductor layer and the side insulation layer is made smaller and upper layers, i.e., another insulation layer and conductor wiring layers are further formed therein, the influence of unevenness or irregularity due to the difference in height between them is reduced to enable the upper layers to be formed with ease. Further, through adjustment of the ground amount, the thickness (i.e. height) of the conductor wiring layer and the side insulation layer can be adjusted to a desired value.

In the meantime, in the above described aspects, after the step of forming the side insulation layer, at least the side surface of the groove and the upper surface of the lower insulation layer exposed to the groove or defining the bottom of same can be roughened, i.e., be subjected to a surface roughening process.

Furthermore, after the step of forming the side insulation layer, a conditioner step for attaching a cation surface active agent to at least the side surface of the groove and the upper surface of the lower insulation layer exposed to the bottom of the grove can be done.

Further, the step for attachment of the catalytic nuclei for plating can be such one that consists of catalyst treatment and accelerating treatment. Furthermore, attachment of the catalytic nuclei for plating can be done by sensitizer treatment and activator treatment.

Further, it is desirable to conduct, after the etching resist layer is removed or after the surface arrangement, blackening treatment of the upper surface of the unremoved conductor layer or form a surface roughened layer on the surface of the unremoved conductor layer by plating since it becomes possible to make higher the joining strength of the conductor layer relative to the insulation layer to be formed then. In the meantime, the process of forming the surface roughened layer can be done, as for example disclosed in Japanese provisional patent publication No. 6-283860, by immersing the circuit board or work in electroless plating solutions containing Cu compounds such as copper sulfate, Ni compounds such as nickel sulfate or hypophosphate such as sodium hypophosphite and thereby forming on the unremoved conductor layer a surface roughened layer containing eutectic compounds composed of Cu, Ni and P.

The above described structures and methods are effective for solving the above noted problems inherent in the prior art device and method.

It is accordingly an object of the present invention to provide a novel and improved circuit board which can assuredly prevent occurrence of migration and a short circuit between conductor wiring layers while making it possible to form conductor wiring layers according to a pattern with accuracy, and further which does not cause any space between a side insulation layer and a conductor wiring layer and therefore does not cause any stain or crack in an insulation layer.

It is another object of the present invention to provide a method of producing a circuit board of the foregoing character.

### BRIEF DESCRIPTION OF THE DRAWINGS

Fig. 1 is a sectional view of a circuit board according to a first embodiment;
Figs 2A to 2F are illustrations of a making example 1-1 of making the circuit board of Fig. 1;
Figs. 3A to 3G are illustrations of another making example 1-2 of making the circuit board of Fig. 1;
Figs. 4A to 4G are illustrations of a further making example 1-3 of making the circuit board of Fig. 1;
Figs. 5A to 5E are illustrations of a further making example 1-4 of making the circuit board of Fig. 1;
Figs. 6A to 6E and 6C' are illustrations of a further making example of making the circuit board of Fig. 1;
Fig. 7 is a sectional view of a circuit board according to the second embodiment of the present invention;
Fig. 8 is a sectional view of a circuit board according to the third embodiment of the present invention;
Figs. 9A to 9K are illustrations of a making example 3-1 of making the circuit board of Fig. 8;
Figs. 10A to 10J are illustrations of another making example 3-2 of making the circuit board of Fig. 8;
Fig. 11 is a sectional view of a circuit board according to the fourth embodiment of the present invention;
Figs. 12A to 12F are illustrations of a prior art method of making a circuit board; and
Figs. 13A to 13D are sectional views of a prior art circuit board.

### DETAILED DESCRIPTION OF THE PREFERRED EMBODIMENTS

Referring to the attached drawings, preferred embodiments and process examples will be described hereinafter.

### (First embodiment)

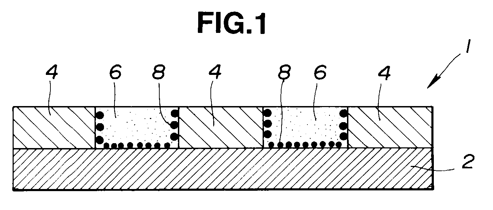

Fig. 1 shows a circuit board 1 according to the first embodiment. The circuit board 1 is of the kind having only one conductor wiring layer 6.

The circuit board 1 includes a lower insulation layer 2 made of bismaleimide triazine (BT) resin so as to be 6 mm thick and serve as a substrate, a side insulation layer 4 formed on the insulation layer 2 and made of photosensitive epoxy resin, and conductor wiring layers 6 made of copper and on the lower insulation layer 2 and each having side surfaces in contact with corresponding layer sections of the side insulation layer 4, respectively. Along the interface between the bottom of each conductor wiring layer 6 and the upper surface of the lower insulation layer 2, there are provided catalytic Pd nuclei for plating which accelerate adherence and development of Cu at the time of forming the conductor wiring layers 6 by electroless plating. Further, also along the interface between each side surface of each conductor wiring layer 6 and the corresponding side surface of each of the layer sections of the side insulation layer 4, there are provided catalytic Pd nuclei 8 for plating.

Such catalytic nuclei 8 causes the conductor wiring layer 6 to be adhered strongly to the lower insulation layer 2 and the side insulation layer 4, while making it possible to solve the problems (1) and (3) since not provided to the interface of the lower insulation layer 2 and the side insulation layer 4. That is, it becomes possible to prevent occurrence of migration between the adjacent conductor wiring layers 6, a short circuit, and a defective wiring due to lack or insufficiency of the conductor wiring layers 6. Further, since the adherence of the matching side surfaces of each layer section of side insulation layer 4 and each conductor wiring layer 6 is high and there is not caused any space between them, there never occurs such a case in which plating solution remaining in the space causes a stain and lowers the insulation property, and further it becomes possible to prevent occurrence of a crack or cracks in the lower insulation layer 2 who the circuit board 1 is subjected to the above described temperature cycling test.

Then, various methods of making the circuit board 1 of Fig. 1 will be described.

### (Making Example 1-1)

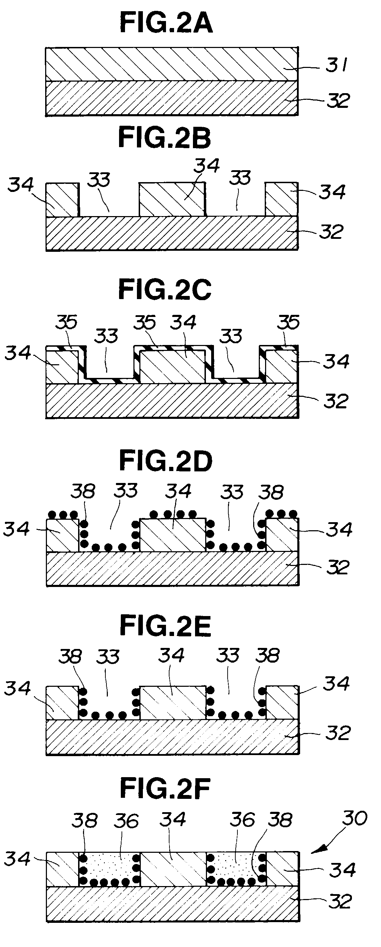

Figs. 2A to 2F show a method of making the circuit board of Fig. 1. In Fig. 2A, there is shown a process in which an insulation layer 31 of photosensitive epoxy resin is applied, by using a roll coater, to an upper surface of a lower insulation layer 32 which is made of BT resin similarly to the above, so as to cover or coat the same. The insulation layer 31 has such a thickness that is equal to the sum of the final thickness of the conductor wiring layer 36 which is 15 µm and the thickness of the conductor wiring layer 36 which is removed by grinding. In the meantime, the upper surface of the lower insulation layer 32 is roughened so as to have the roughness average (Ra) of abut 5 µm by buffing or the like prior to the above described covering or coating thereof, so the insulation layer 31 can be coated and formed firmly thereon. Further, the above described photosensitive resin can be either of the solvent development type and the alkali development type.

Then, by way of a mask having a predetermined wiring pattern through which light can pass, ultraviolet rays are irradiated on the insulation layer 31 to reduce the solubility of the exposed portion of the photosensitive resin. The insulation layer 31 is then immersed in the developing solution for its solvent cleaning, so that unexposed portions of the insulation layer 31 are removed. At the portions from which the unexposed portions of the insulation layer 31 have been removed in the above manner, grooves 33 are formed as shown in Fig. 2B, and at the opposite sides of each groove 33 there are formed layer sections of a side insulation layer 34.

In Figs. 2A to 2F, each groove 33 is shown by way of example so as to have nearly vertical side surfaces. However, depending on the exposure condition, etc., the groove 33 can be formed otherwise, i.e., can be tapered upward or downward.

In this connection, when the side surfaces are nearly vertical, the distant between the adjacent two conductor wiring layers can be set minimum, so such groove shape is useful in case of forming a fine conductor wiring. On the other hand, in case the side surfaces are tapered upward, good circulation of the plating solution can be attained, so such side surfaces are useful and desirable for the reason that the plating layer can be formed with ease.

In the meantime, the above described pattern making technology is of the so-called negative type but can be of the positive type.

Then, the surfaces (i.e., upper surface and side surface) of the side insulation layer 34 obtained as above and the upper surface of the lower insulation layer 32 exposed to the groove 33 are etched by the solution of potassium chromate or potassium permanganate to remove the residue of the photosensitive resin remaining at the bottom of the groove 33 (desmear treatment) and roughen those surfaces in such a way that they are finely irregular. Such surface roughing improves the adherence of the conductor wiring layers 36 to the side insulation layer 34 end the exposed upper surface portion of the lower insulation layer 32.

Then, the surfaces of the side insulation layer 34 and the exposed upper surface portion of the lower insulation layer 32 are treated by conditioner. That is, as shown in Fig. 2C, cation surface active agent 35 is attached to the surfaces of the side insulation layer 34 and the exposed upper surface portion of the lower insulation layer 32. The cation surface active agent 35 is for example polyoxyethlenealkylamine. The work or the lower insulation layer 32 and so on are immersed in the solution of polyoxyethlenalkylamine to attach the surface active agent 35 to the above described surfaces by the affinity of the hydrophobic group of the both. The conditioner treatment is carried out with a view to increasing the attaching amount of catalytic nuclei and is not an indispensable treatment for the method of this invention. However, by increasing the attaching amount of catalytic nuclei, the adherence of the conductor wiring layers 36 to the side insulation layer 34 and the lower insulation layer 32 can be improved.

Further, as shown in Fig. 2D, catalytic nuclei 38 for plating are attached to the entire surface of the above described surface active agent 35. This attaching process consists of two treatments, i.e., a catalyst treatment and an accelerating treatment. The catalyst treatment is for attaching a colloid containing Pd and Sn to the above described surfaces, and for this end the colloidal solution of OPC-80 of Okuno Pharmaceutical Co. make was used. In the meantime, since the colloid (colloidal particles of the diameter of 300 to 600 angstroms) is negatively charged, the colloidal particles are attracted by the cation surface active agent attached to the surfaces by the above described conditioner treatment, so the conditioner treatment makes it possible to attach by the more amount and uniformly the colloidal particles to the surfaces of the side insulation layer 34 and the exposed upper surface portion of the lower insulation layer 32.

Then, an accelerating treatment is applied to the surfaces. That is, the work or the lower insulation layer 32 and so on are immersed in the accelerator treatment solution consisting of diluted sulfuric acid of the concentration within the range from 5 to 10 %, for about one minutes. By this, Sn compounds in the above described colloid are dissolved by the diluted sulfuric acid and removed. Thus, the catalytic Pd nuclei 38 remain on the surfaces of the side insulation layer 34 and the exposed upper surface portion of the lower insulation layer 32. In the meantime, if this treatment is not performed sufficiently, some Sn remains unremoved and is dissolved into the electroless copper plating solution to form Cu-Sn compounds, i.e., Sn precipitates again, so care must be taken about this treatment.

The side insulation layer 34 is grounded to remove its upper end portion and to the thickness of abut 15 µm, whereby the catalytic nuclei 38 having been adhered to the upper surface of the side insulation layer 34 are removed. Thus, the lower insulation layer 32, side insulation layer 34 and so on in the state shown in Fig. 2E are obtained. In order to remove the upper end portion of the side insulation layer 34 on the upper surface of which the catalytic nuclei 38 for plating have been attached, uniformly by the thickness within the range from 1 to 20 µm, preferably within the range from 5 to 10 µm, the above described grinding is carried out by tape grinding, buffing, belt grinding or the like. When the grinding amount is set to 5 µm or more, the catalytic nuclei 38 for plating having been adhered to the upper surface of the side insulation layer 34 can be assuredly. On the other hand, when the ground amount is set to 10 µm or less, variations of the actual ground amount can be restricted within a desired range, so it becomes possible to maintain the thickness of the side insulation layer 34 above a predetermined value.

In case of tape grinding, it is desirable to use such a tape of the grit size ranging from #300 to #1000 or so, for example, by carrying out the tape grinding under the condition that a grinding tape is of the grit size of #600, the feed speed of the tape is 2mm/sec, the feed speed of the work (i.e., ground object) is 10 mm/min, and the work is ground in four different directions, it was possible to provide the side insulation layer 34 with a smooth ground surface without any peeling or exfoliation with efficiency.

In case of buffing, it is desirable to use a buff of the grit size ranging from #220 to #1000 or so. For example, by using a grinding wheel of the grit size of #600 and carrying out the buffing at the speed (i.e., rotational speed) of the wheel of about 1000 rpm for about five minutes, a good ground surface similar to the above was obtained.

Further, in case of belt grinding, it is desirable to use a belt of the grit size ranging from #300 to #1000 or so. For example, by using a grinding belt of the grit size of #600 and carrying out the grinding at the speed (i.e., rotational speed) of the grinder of about 600 rpm and at the feed speed of the work (i.e., ground object) of 2 m/min, a good result was obtained.

In the meantime, by making smaller the grit sizes of the abrasives, the time necessary for completing the grinding can be made shorter. However, when the grit size smaller than #300 is selected in case of tape grinding or belt grinding, peeling or exfoliation is caused at the surface of the side insulation layer 34 or variations in the ground depth are caused at some portions, so it is desirable to use the abrasive of the grit size of #300 or more.

After, the above described grinding, electroless copper plating is carried out to form within the grooves 33 conductor wiring layers 36 of Cu as shown in Fig. 2F. The plating solution used was MCU-H of Word Metal Co. make, and the work was immersed in the plating solution of about 65 °C and held therein for about three hours and at the plating speed of 5 µm/h. Reduction and precipitation of the Cu ions in the plating solution start at the catalytic nuclei 38, and on the surfaces of the thus precipitated Cu particles there further occur precipitation of Cu to cause development of the precipitated Cu particles, thus filling the grooves 33 with Cu. As a result, the conductor wiring layers 36 of 30 µm in width was obtained. In this connection, the side insulation layer 34 located between the conductor wiring layers 36 is 30 µm at the smallest portion thereof.

Further, by applying, prior to the above described electroless copper plating which is fast in the plating precipitation (i.e., of the high speed precipitation type), flash Ni plating (e.g., a build copper plating solution of Okuno Pharmaceutical Co. make) which is slow in the plating precipitation (i.e., of the low speed precipitation type), it becomes possible to make firmer the adherence of the conductor wiring layers 36 to the lower insulation layer 32 and the side surfaces of the side insulation layer 34. The flash plating is slow in the plating precipitation but can be applied to all the portions of the irregular surface.

In the last or final step, it is performed finish grinding for removing the upper end portions of the side insulation layer 34 and each conductor wiring layer 36 by the thickness of several micron meters and thereby make all of uniform thickness of 15 µm, whereby to complete the circuit board 30.

In the meantime, the side insulation layer 34 is called permanent resist or permanent mask since once applied, it remains as it is except for the portions for forming the grooves 33.

### (Making Example 1-2)

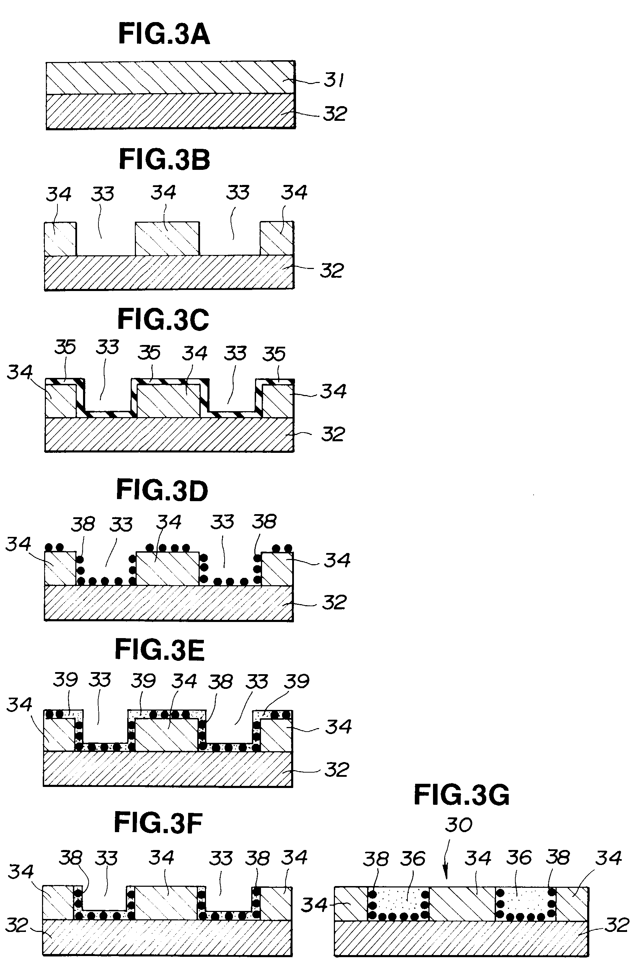

Figs. 3A to 3G show a variant of the method of making the circuit board of Fig. 1. In Figs. 3A to 3D, the formation of the insulation layer 31, the formation of the side insulation layer 34 by exposure and development of the insulation layer 31, attaching of the cation surface active agent 35 and attaching of the catalytic nucleis 38 for plating are the same with those in the above described making example 1-1.

Then, as shown in Fig. 3E, the entire upper surface of the side insulation layer 34 and the grooves 33 are electroless copper plated to form a copper layer 39 of 5 µm or less in thickness. The reason why the thickness of the copper layer 39 is set to 5 µm or less is for making easier the grinding in the next process.

In this connecion, in order to improve the adherence to the side insulation layer 34 or the lower insulation layer 32, flash Cu plating which is slow in the plating precipitation or deposition was used as the electroless copper plating, and the Cu layer of the thickness ranging from 0. 5 to 3 µm was formed.

Then, as shown in Fig. 3F, by the same process as the making example 1-1, i.e., by tape grinding, buffing, belt grinding or the like process, a portion of the Cu layer 39 which is formed on the side insulation layer 34 and the upper end portion of the side insulation layer 34 are removed. Thereafter, normal electroless copper plating is carried out to form conductor wiring layers 36.

By grinding the entire of the work similarly to the above described making example 1-1, a circuit board 30 having within each groove 33 a conductor wiring layer 36 of 30 µm in width and catalytic nuclei 38 along the interface between each side surface and the bottom space of each conductor wiring layer 36 as shown in Fig. 3G, was obtained.

### (Making Example 1-3)

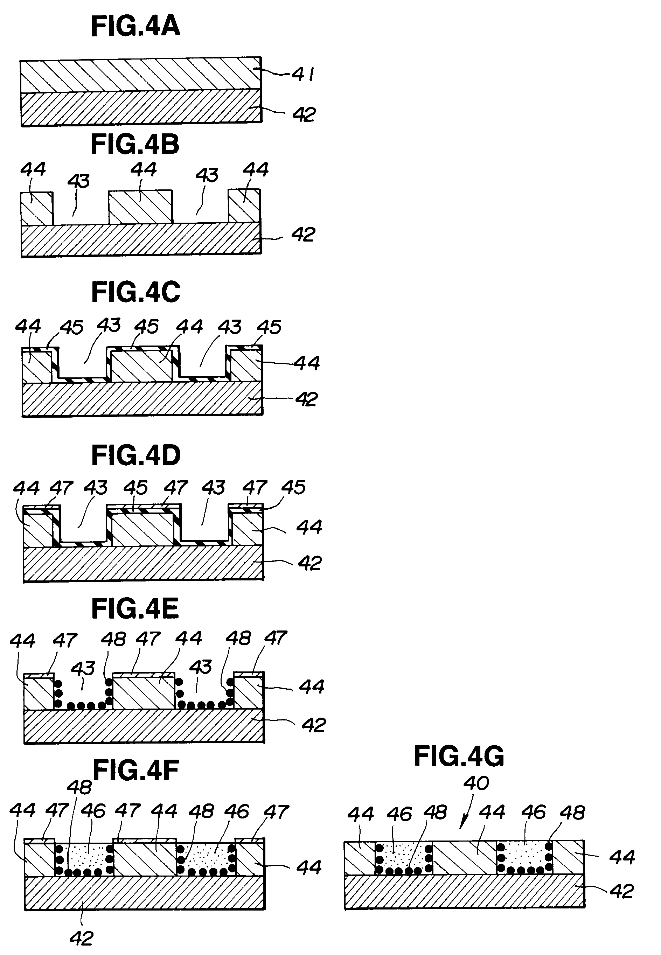

Figs. 4A to 4G show another variant of the method of making the circuit board of Fig. 1. Firstly, as shown in Fig. 4A, the upper surface of the lower insulation layer 42 is roughen to form the insulation layer 41 thereon similarly to the above described making example 1-1. Then, as shown in Fig. 4B, the patterned side insulation layer 44 and the grooves 43 are formed, and the surfaces (upper surface and side surfaces) of the side insulation layer 44 and the exposed upper surface portion of the lower insulation layer 42 are roughened by etching similarly to the manner described before. Thereafter, as shown in Fig. 4C, cation surface active agent 45 is attached thin to the above surfaces by a conditioner treatment. The foregoing process is the same as that in the making example 1-1.

Then, in this making example, as shown in Fig. 4D, only the upper surface of the side insulation layer 44 is coated with a thin silicon resin layer 47 having a good water repellency. The coating of silicon resin is attained by using a masking tape having on one side surface silicon adhesive containing silicon resin (making tape of Teraoka Co. make and of an article number of PCT-647), attaching this tape to the upper surface of the side insulation layer 44, subjecting the tape to a cycle of hot water washing at 60 °C for one minute and water washing at 20 °C for one minute and repeating this cycle five times, and thereafter tearing off the tape to transfer the silicon adhesive on the side insulation layer 44. Since such silicon resin is inactive, high in the water repellency and low in the adhesive ability with respect to colloid, it can prevent, in the next step, the catalytic nuclei 48 for plating from sticking or adhering to the upper surface of the side insulation layer 44. In the meantime, a resin having a similar water repellency, such as fluororesin can be used in place of silicon resin.

Further, the thin silicon resin layer 47 coating method can be carried out by rolling a dust removing roller provided with silicon adhesive several turns on the upper surface of the side insulating layers 44 and thereby transferring silicon resin to the same, or by using a roll coater having applied thereto silicon resin for such transfer and attaching the silicon resin to the upper surface of the side insulation layer 44 and thereafter making it hardened by heating.

Then, catalysis treatment is applied to the work to attach colloid containing Pd and Sn to the bottom and side surfaces of the above described groove 43. Further, for accelerating treatment, the work is immersed in dilute sulfuric acid solution to dissolve and thereby remove the Sn compounds in the colloid and make a cluster of Pd catalytic nuclei 48 remain on the bottom and side surfaces of the groove 43, i.e., along the boundary surface with respect to the conductor wiring layers 46. In this connection, the catalytic nuclei 48 do not adhere to the upper surface of the side insulation layer 44 since the silicon resin layer 47 exists or is present on that upper surface.

Further, when electroless plating similar to that described hareinbefore is carried out, copper (Cu) is deposited only on the catalytic nuclei 48 for plating which are adhered to the bottom surface and the both side surfaces of the groove 43 and such deposition develops to form the conductor wiring layers 46 within the groves 43 soon as shown in Fig. 4F.

In the meantime, as described with respect to the making example 1-1, by firstly carrying out low-speed electroless plating and than carrying out electroless plating which is high in deposition speed, the adherence between each of the insulation layers 42 and 44 and the conductor layer 46 can be made higher or larger.

In the last step, the upper portions of the side insulation layer 44 and the conductor wiring layer 46 are removed by the thickness of about several µm including the thickness of the thin silicon resin layer by grinding, a circuit board 40 having the side insulation layer 44 and the conductor wiring layers 46 which are uniform in thickness as shown in Fig. 4G was obtained.

### (Making Example 1-4)

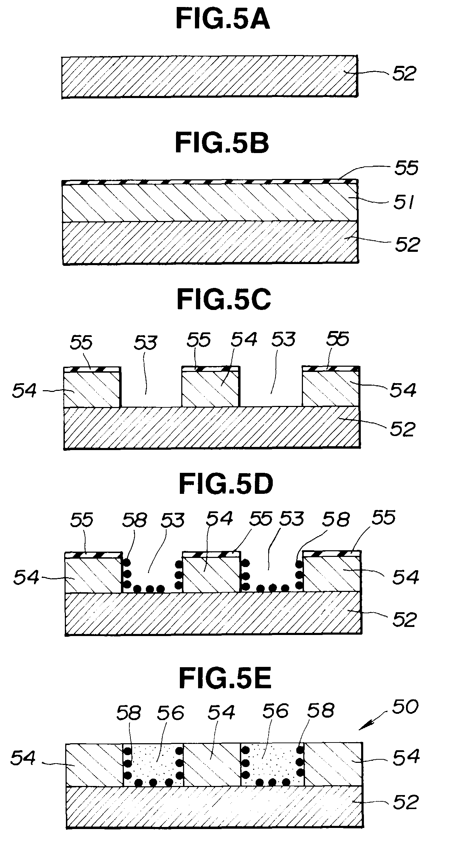

Figs. 5A to 5E shows a further variant of the method of making the circuit board of Fig. 1. Fig. 5A shows a lower insulation layer 52 that constitutes a similar substrate to that described hereinbefore. On the lower insulation layer 52 there is formed a photosensitive resin layer 51. To the photosensitive resin, there are added by 3% to 5% reactive macromolecule having at the end of monomer of water repellent resin such as silicon resin and the like the hydroxyl group or dicarboxyl group as the functional group. By application of such photosensitive resin and drying and polymerization of same, the reactive macromolecule added to same is made to float to form a thin layer, so on the upper surface of the photosensitive resin layer 51 there is formed, as shown in Fig. 5B, a thin graft polymer layer 55 having silicon as a branched component and having a water repellency. In the meantime, as the above described reactive macromolecule, macromonomer HK-20 of Toa chemical industry, Co. make was used.

Then, by exposure and development of the work of Fig. 5B, a side insulation layer 54 having the thin graft polymer layer 55 at the upper surface thereof and grooves 53 are formed as shown in Fig. 5C. Then, the catalysis treatment and the accelerating treatment are carried out for attaching catalytic nuclei 58 for plating to the work of Fig. 5C. The catalytic nuclei 58 for plating are thus attached to the bottom and side surfaces of the groove 53 but not to the upper surface of the side insulation layer 54 since the thin graft polymer layer 55 having water repellency is provided to the upper surface of the side insulation layer 54. By carrying out electroless copper plating, conductor wiring layers 56 are formed within the grooves 53 having attached to the surfaces thereof the catalytic nuclei 58.

Then, by carrying out finish grinding similar to that described hereinbefore, the upper end portions of the side insulation layer 54 and the conductor wiring layers 56 are removed together with the thin graft polymer layers 55, and a circuit board 50 as shown in Fig. 5E was obtained.

### (Making Example 1-5)

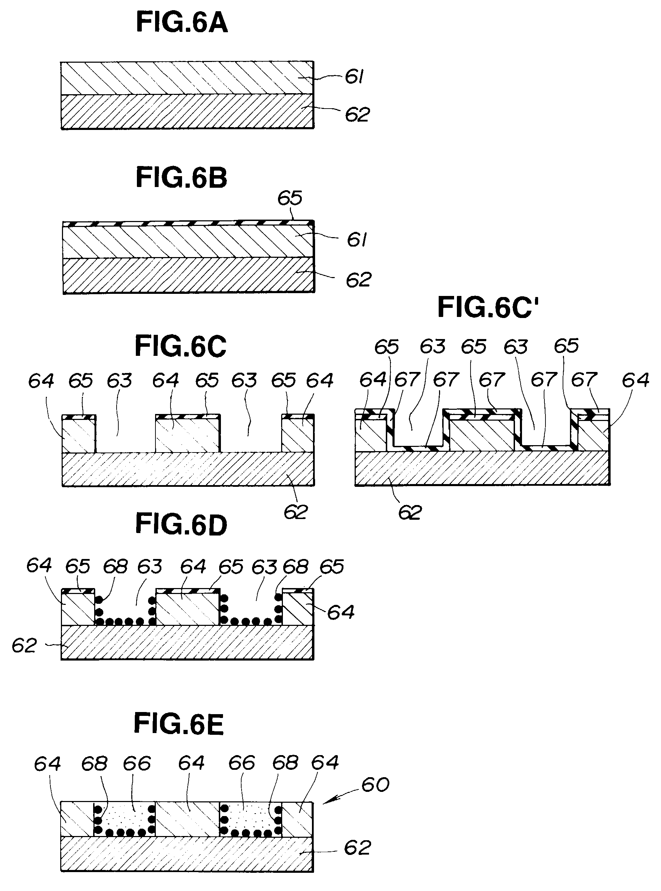

Figs. 6A to 6E show a further variant of the method of making the circuit board of Fig 1. In this embodiment, anion surface active agent is used.

Fig. 6A shows a lower insulation layer 62 serving as a substrate and an insulation layer 61 made of photosensitive resin and applied to the lower insulation layer 62. In this connection, it is desirable to use photosensitive resin of the solvent developing type. When the alkali developing type is used, cations in the alkali developing solution are attached to the anion surface active agent that is to be attached to the upper surface of the insulation layer 61 in the next process, so there cannot be obtained any effect that is expected to be produced by using an anion surface active agent or the affect becomes smaller.

Then, ultraviolet rays for obtaining a wiring pattern are irradiated to the surface of the insulation layer 61 and thereby carry out exposure of same. Thereafter, as shown in Fig. 6 B, anion surface active agent 65 is applied to the upper surface of the insulation layer 61. Alkyl benzene sulfonate is used as the anion surface active agent 65, and in the solution of same the insulation layer 61 is immersed and then dried. In the meantime, when such drying is carried out, the adherence of the active agent 65 and the insulation layer 61 is improved, so it becomes possible to prevent dislodgment or escape of the anion surface active agent from the upper surface of the insulation layer 61 at the time of solvent development.

Then, the insulation layer 61 is immersed in the development solution to remove the part of the insulation layer 61 to which the ultraviolet rays have not been irradiated, together with the anion surface active agent 65 thereon. Then, as shown in Fig. 6C, the side insulation layer 64 and the grooves 63 are formed after a predetermined pattern.

As shown in Fig. 6D, catalytic nuclei 68 for plating are applied to the inside of the grooves 63, i.e., the side surfaces of the side insulation layer 64 and the exposed upper surface portion of the lower insulation layer 62. To carry out the catalysis treatment, the work of Fig. 6D is immersed in Pd-Sn colloid solution. In this instance, since the colloid is charged negative, it repels the anion surface active agent 65 having been attached to the upper surfaces of the side insulation layer 64 and is not attached to the upper surface of the side insulation layer 64. On the other hand, the both side surfaces and the bottom surface defining the groove 63 attract the colloid since the anion active surface agent 65 is not attached to those surfaces.

Then, to carry out the accelerating treatment, the work of Fig. 6D is immersed in the dilute sulfuric acid solution to remove the Sn compound in the colloid. By this, catalytic Pd nuclei 68 are attached to the above described both side surface of the side insulation layers 64 and the exposed upper surface portion of the lower insulation layer 62.

By carrying out electroless copper plating similar to that described above, copper (Cu) is deposited on the surface of the catalytic nuclei 68 attached to the bottom and side surfaces defining the groove 63 and developed, whereby cooper conductor wiring layers 66 could be formed within the grooves 63. In the meantime, similarly to the making example 1-1, by carrying out low-speed electroless plating first and then high-speed electroless plating, the adherence of each of the insulation layers 62 and 64 and the conductor wiring layer 66 can be improved.

In the last or final step, finish grinding similar to that described before is carried out, and a circuit board 60 shown in Fig. 6E was completed.

Further, in the method of this embodiment, conditioner treatment can be made optionally.

That is, after the side insulation layer 64 is formed as shown in Fig. 6C, a cation active surface agent 67 is formed by conditioner treatment on the upper and side surfaces of the side insulation layer 64 and on the exposed upper surface portion of the lower insulation layer 62 as shown in Fig. 6C'. By this treatment, the anion surface active agent 65 having been previously attached to the upper surface of the side insulation layer 64 and the cation surface active agent 67 are electrically offset to each other and thereby put into an electrically uncharged condition. On the other hand, only the cation surface active layer 67 is attached to the above described both side surfaces and the bottom surface defining the groove 63, so in the next step the catalytic nuclei 68 for plating are attached uniformly to those surfaces similarly to that shown in Fig. 6D.

However, in such conditioner treatment, if the amount of cation surface active layer 67 attached to the upper surface of the side insulation layer 64 is too many, an effect expected to result from the attachment of the cation surface active agent 65 cannot be obtained. So, it is necessary to carry out adjustment of an agent used and selection of a treatment condition. In this connection, in case a conditioner treatment was carried out by immersing the work of Fig. 6C in the solution of OPC-370M of Okuno pharmaceutical Co. make and of the temperature as high as 40 °C for two minutes, a good result was obtained. However, in case of a treatment of immersing the work in the solution of OPC-370M of Okuno pharmaceutical Co. make and of the temperature as high as 65 °C for five minutes, an excess amount of the cation surface active agent 67 was attached to the upper surface of the side insulation layer 64, so the catalytic Pd nuclei 68 was attached even to the upper surface of the side insulation layer 64.

In the meantime, in the method of this embodiment, it is desirable not to carry out the surface roughening of each insulation layers 62 and 64 by etching. This is for preventing the anion surface active agent 65 having been attached to the upper surface of the side insulation layer 64 from being removed by the surface roughening treatment. Even if such an etching (surface roughening) is omitted, the exposed surface portion of the lower insulation layer 62 has already been roughened prior to being coated by the insulation layer 61, and further the side surfaces of the layer sections of the side insulation layer 64 at the opposite sides of the groove 63 have been roughed to some extent at the time of development, so a sufficient adherence of the insulation layers and the copper conductor wiring layers 66 can be obtained.

### (Second Embodiment)

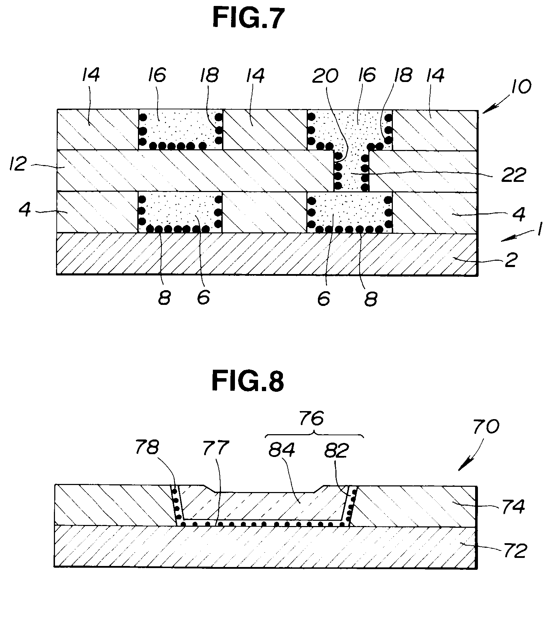

Fig. 7 shows a circuit board 10 according to a second embodiment of the present invention.

The circuit board 10 is formed with multi-layered (two storied) conductor wiring layers. The circuit board 10 has an insulation interlayer 12 which is made of adhesive epoxy resin and formed on the entire surfaces of the side surface layer 4 and the conductor wiring layers 6 of the circuit board 1 of Fig. 1, and further has on the insulation interlayer 12 a side insulation layer 14 made of photosensitive epoxy resin and copper conductor wiring layers 16 which are each located between the adjacent two layer sections of the side insulation layer 14. The interface between each conductor wiring layer 16 and the insulation interlayer 12 and the interface between each conductor wiring layer 16 and the side insulation layer 14 are provided with catalytic Pd nuclei 18 for plating solar to that shown in Fig. 1. In the meantime, further on the side insulation layer 14 and the conductor wiring layers 16 there may be formed another insulation interlayer 12 to cover them and on the insulation interlayer 12 thus further provided there may be formed a further side insulation layer 14 and conductor wiring layers 16 which are provided with catalytic nuclei 18 in the above described manner.

By placing the insulation interlayer 12, the side insulation lab 14 and the conductor wiring layers 16 one upon another in the above described order, a multi-layered circuit board having a desired number of stories of wiring layers can be obtained.

Further, the insulation interlayer 12 between the storied conductor wiring layers 6 and 16 is provided with a through hole 20 at a predetermined place and a via 22 in the through hole 20 for enabling the upper and lower conductor wiring layers 6 and 16 to be conductive to each other. The interface between the side surface or circumferential surface of the via 22 and the insulation interlayer 12 has catalytic nuclei 18 for plating. In the meantime, the through hole 20 can be formed by various processes, e.g., a process of forming the through hole 20 by exposure and development of the insulation layer 12 made of photosensitive resin, a process of forming a through hole by irradiation of a laser beam, and the like.

In the meantime, the insulation interlayer 12 serves as a so-called substrate (i.e., base insulation layer) with respect to the side insulation layer 14 and the conductor wiring layers 16 formed thereon, so it is regarded in this invention as being included in the lower insulation layer.

Then, the method of making the circuit board 10 will be described hereinafter.

The circuit board 10 shown in Fig. 7 can be obtained by the following method. Adhesive epoxy resin is applied to the substantially entire upper surfaces of the side insulation layer and the conductor wiring layers of the circuit board 30, 40, 50 or 60 obtained by either of the above described methods to form the insulation interlayer 12 having the thickness necessary for insulation, i.e., the thickness ranging from 10 µm to 100 µm or so. Then, by either of the above described methods, the patterned side insulation layer 14 and the conductor wiring layers 16 which are each disposed between adjacent two layer sections of the side insulation layer 14, are formed on the insulation interlayer 12.

In this connection, at the same time when the upper conductor wiring layers 16 are formed, the through hole 20 of the insulation interlayer 12 is processed by electroless copper plating to form the via 22. That is, catalytic nuclei 18 for plating are attached to the inside of the groove including the through hole 20 and thus having a T-like cross section, so that by electroless plating the via 22 can be formed simultaneous with the conductor wiring layers 16. Accordingly, as shown in Fig. 7, the catalytic nuclei 18 exist also at the interface between the side surface (circumferential surface) of the via 22 and the insulation interlayer 12.

In this manner, by repeating the process for obtaining the above described insulation interlayer and the process for obtaining the side insulation layer and the conductor wiring layers between the layer sections thereof according to either of the above described methods a desired number of times, a so-called build-up multi-layer circuit board having three-dimensional wiring.

### (Third Embodiment)

Fig. 8 shows a circuit board 70 according to a third embodiment of the present invention.

The circuit board 70 has only one conductor wiring layer 76. The circuit board 70 has a lower insulation layer 72 (about 15 µm thick), side insulation layer 74 and a conductor wiring layer 76 (about 11 µm thick) similarly to the first embodiment. The circuit board 70 has similar Pd catalytic nuclei 78 for plating at the interface between the bottom surface of the conductor wiring layer 76 and the exposed upper surface portion of the lower insulation layer 72. Further, the circuit board 70 has catalytic nuclei 78 for plating at the interface between each side surface of the conductor wiring layer 76 and a corresponding side surface of each of the layer sections of the side insulation layer 74.

Particularly, in this embodiment, the conductor wiring layer 76 is comprised of an electroless Cu plate layer 82 (about 1 µm thick) formed on the surface of the groove 77 and a Cu electroplated layer (about 10 µm thick) 84 formed on the electroless plated layer 82.

Accordingly, this embodiment can produce substantially the same effect as the first embodiment. In addition, since the most of the conductor wiring layer 76 is constituted by the electroplated layer 84, it is so dense and superior in the physical properties such as ductility, tensile strength, conductivity and the like, so the possibility of occurrence of a crack or cracks in the conductor and the insulation layer is eliminated or considerably reduced.

Further, since the most of the conductor wiring layer 76 is formed by electroplating, there is such an advantage that a period of time or hour necessary for plating is shorter and control of plating solution is simplified as compared with the case where the conductor wiring layer 76 is formed only by electroless plating. Furthermore, since the work is not immersed in electroless plating solution of strong alkali (≧ pH12) for a long time, the more kinds of materials can be used for the side insulation layer 74.

In the meantime, in this embodiment, the conductor wiring layer 76 is shown as being recessed a little at the central part thereof, the upper surface of the conductor wiring layer 76 can be made flush with the upper surface of the side insulation layer 74.

Then, the method of making the circuit board 70 shown in Fig. 8 will be described.

### (Making Example 3-1)

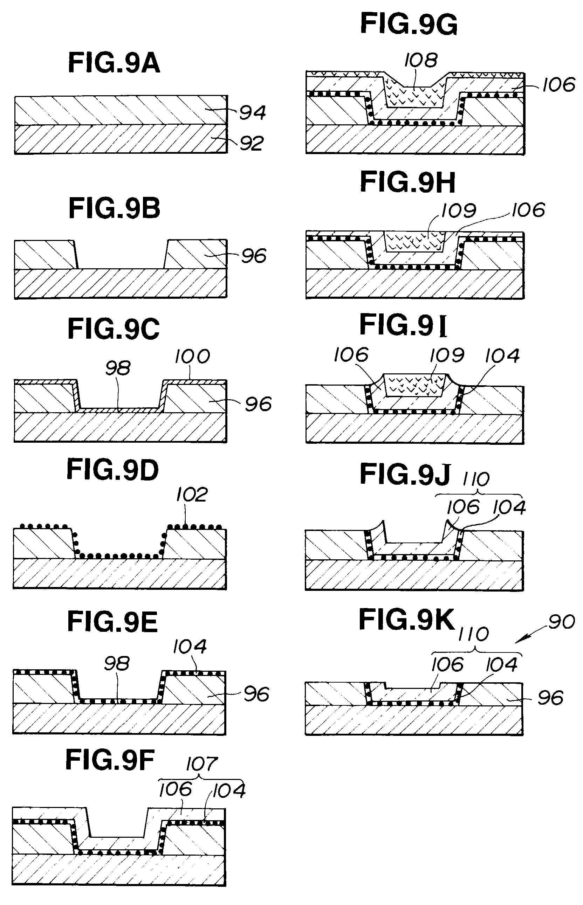

Figs. 9A to 9K show a method of making a circuit board of Fig. 8. In the meantime, the process steps shown in Figs. 9A to 9D are substantially similar to those of Figs. 2A to 2D in the above described Making Example 1-1, so description thereto is omitted or simplified for brevity.

As shown in Fig. 9A, photosensitive epoxy resin is applied to an upper surface of a lower insulation layer 92 to form an insulation layer 94 of about 20 µm in thickness. Then, as shown in Fig. 9B, the insulation layer 94 is processed by wiring pattern exposure and development to form a side insulation layer 96.

In the meantime, in Figs. 9A to 9K, the shape of the groove 98 is shown different from that in the first and second embodiments, i.e., shown by way of example so as to taper downward. As having been described hereinbefore, the groove 98 can be formed variously depending upon exposure conditions, i.e., can be formed into the shape having tapered side surfaces, vertical side surfaces or reversely tapered side surfaces.

In case of the vertical side surfaces, the groove 98 is convenient for forming therein a fine patterned conductor wiring layer. On the other hand, in case the side surfaces taper downward (i.e., becomes wider toward the upper end), good circulation of the plating solution can be obtained, so the plated layer can formed with ease and therefore this shape is convenient and desirable in this respect as described hereinbefore. Further, in this embodiment, when the side surfaces are tapered, an etching resist layer 109 formed above the groove 98 is formed into a trapezoidal shape which is wider at the upper end, so the area of the conductor wiring layer 106 which is covered by the resist layer 109 becomes a little larger. This is convenient since the conductor wiring layer 106 having a wider area can be remained.

Then, as shown in Fig. 9C, the upper surface of the side insulation layer 96 and the surface of the grove 98 are roughened, and surface active agent 100 is attached to the roughened surfaces. Further, as shown in Fig. 9D, catalytic nuclei 102 for plating are attached to the entire surface of the surface active agent 100.

Then, as shown in Fig. 9E, the upper surfaces of the side insulation layer 96 and the surface of the groove 98 to which the catalytic nuclei 102 for plating are attached, are processed by electroless copper plating and entirely covered by an electroless plated layer 104 of about 1 µm in thickness. For the plating solution, MCU-H of Word Metal Co. make was used, and the work of Fig. 9F was immersed in the plating solution at the temperature as high as about 65 °C and processed at the plating or deposition speed of 5 µm/hour for about 12 minutes.

In the meantime, in place of such electroless copper plating which is high in the deposition speed (of the high-speed deposition type), flash Ni plating (by the use of PN-FF plating solution of Word Metal Co. make) or flash Cu plating (by the use of build copper plating solution of Okuno Pharmaceutical Co. make) which is low in the deposition speed (i.e., of the low-speed deposition type) can be carried out, or they can be combined suitably.

Then, as shown in Fig. 9F, copper electroplating is carried out with the electroless plated layer 104 being connected as a cathode, whereby an electroplated layer 106 of about 10 µm in thickness and covering the entire surface of the electroless plate layer 104 is formed. By this, a conductor layer 107 of about 11 µm in thickness, which is formed into a conductor wiring layer 110 in a later process, is formed.

Though such an electroplating technology or process is well known in the art, it can be carried out by way of example under the following conditions:
sulfuric acid - 160g/liter; copper sulfate - 50 to 70 g/litter; chlorine ion - 30 to 60 mg/litter; cathode current density - 2..0 A/dm²; hot bath - 24 to 26 °C; period of time for deposition - 30 minutes.

Then, as shown in Fig. 9G, etching resist is applied so as to cover the entire surface of the electroplated layer 106 to form an etching resist film or coating 108. The etching resist is made of heat curing epoxy resin and its material in a paste state is applied by printing to form the etching resist film 108. In the meantime, a larger quantity of etching resist is applied on the portion of the conductor layer 107 above the groove 98 since that portion is recessed, so the etching resist film 108 becomes thicker at that portion.

Then, as shown in Fig, 9H, the surface of the etching resist film 108 is ground and removed until at least the electroplated layer 106 is exposed. Accordingly, after the grinding, the etching resist remains only in the place corresponding to the groove 98 (i.e., the place at which a conductor wiring layer 110 is to be formed) to form an etching resist layer 109. As a technology for such grinding, various grinding such as tape grinding, buffing, belt grinding as described with respect to the Making Example 1-1 can be employed. In the meantime, in order to remove the etching resist film 108 on the side insulation layer 96 completely, it is desirable to remove a predetermined amount of the electroplated layer 106 by grinding (e.g., by the thickness within the range from 1 to 5 µm). In the meantime, since the thickness of the electroplated layer 106 to be removed by grinding is small, such removal by grinding can be attained without so much difficulty.

Then, as shown in Fig. 9I, etching is carried out to remove the portion of the electroplated layer 106 and the portion of the electroless plated layer 104 from which the etching resist layer 108 is removed. For this etching, an etching solution consisting of an aqueous solution of 25% ferric chloride or cupric chloride is used. In the meantime, it will do to use an etching machine that is used in a subtractive process, for spraying the etching liquid over the word carried on a conveyor and thereby carrying out the etching continuously.

Then, as shown in Fig. 9J, the etching resist layer 109 remaining in the place corresponding to the groove 98 is removed. This removal of the etching resist layer 109 is obtained by spraying a methylene chloride solution over the work to exfoliate the etching resist layer 109. The the same end, the work may be immersed in a methylene chloride solution to dissolve the etching resist layer 109. Further, organic solutions such as solutions of xylene, acetone and the like can be used.

In the meantime, the upper ends of the electroplated layer 106 which do not have been etched at the step of Fig. 9I but remain, have corner portions (upper end inside portions) in contact with the etching resist layer 109, the corner portions being sometimes formed into a horn-like or beard-like shape due to bad circulation of the etching solution at that corner portions.

In the last step, as shown in Fig. 9K, the upward protruded upper end inside portions of the conductor wiring layer 110 consisting of the electroplated layer 106 and the electroless plated layer 104 and the upper end portion of the side insulation layer 96 is ground and removed by tape grinding, buffing, belt grinding or the like until the side insulation layer 96 is ground to the thickness of about 15 µm, whereby to complete the circuit beard 90.

In this manner, in this embodiment the electroless plated layer 104 is first formed all over the upper surface of the work including the groove 98 and thereafter the thick electroplated layer 106 is formed by connecting the electroless plated layer 104 as an electrode, so the conductor wiring layer 110 having excellent physical properties can be obtained with ease.

Further, in case the etching resist film 108 formed on the electroplated layer 106 is to be removed by grinding, the portion of the etching resist film 108 within the recessed portion of the conductor layer 107 above the groove 98, i.e., the portion of the etching resist layer 109 above the portion of the conductor layer 107 which is to be formed into the conductor wiring layer 110, is not removed, so by etching carried out later the electroless plated layer 104 and the electroplated layer 106 can be removed assuredly except for the portions that constitute the conductor wiring layer 110. Accordingly, by carrying out grinding thereafter for arrangement of surface, the conductor wiring layer 110 can be obtained with ease.

Particularly, this making method has an advantage that by strong etching and grinding at the last or final process, the unnecessary portions of the catalytic nuclei 102, the electroless plated layer 104 and the electroplated layer 106 can be removed easily and completely.

In the meantime, the grinding at the process of Fig. 9K can be made in a way as to remove only the above described upper end inside corner portions.

In the meantime, in the above described Making Example 3-1, it has been described and shown such a method wherein the etching resist film 108 is first formed and then removed by grinding except for the portion above the groove 98. This can be replaced by such a method wherein a dry film of etching resist is vacuum laminated (i.e., attached) to form the etching resist film 108 and then ground to remove the unnecessary portion similarly to the above.

Further, it can be employed such a method wherein etching resist is applied and extended over the conductor layer 107 by squeezing and is forced into the recessed portion above the groove 98 to form the etching resist film 108 and the etching resist film 108 is treated by resin etching by potassium chromate, potassium permanganate or the like for thereby not removing the thick portion of the etching resist layer 109 above the groove 98 but removing the remaining thin portion of the same. By doing so, the process can be proceeded from the beginning to the last only by chemical treatments and by not intervening a mechanical step such as grinding between some steps thereof.

### (Making Example 3-2)

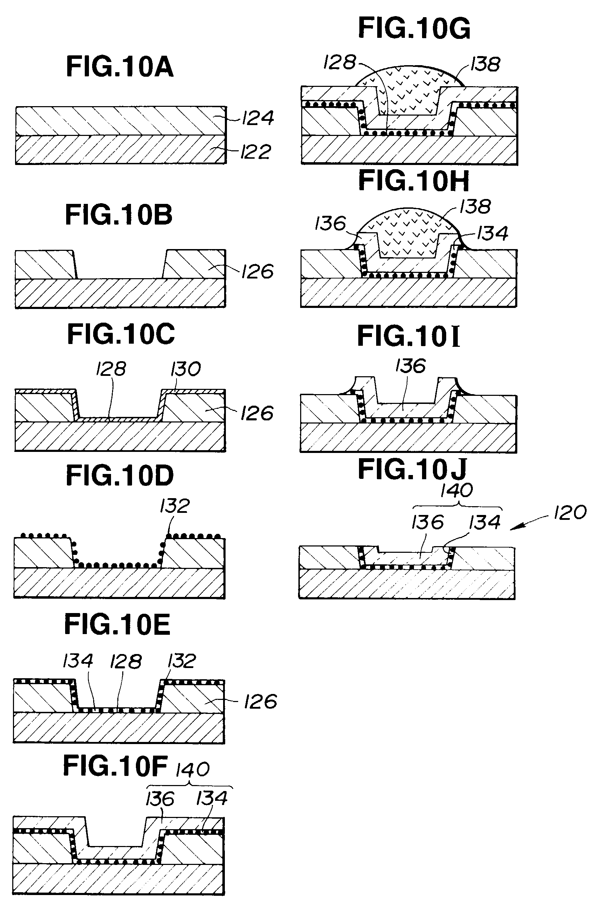

Figs. 10A to 10J show a variant of the method of making the circuit board of Fig. 8. In the meantime, the processes of Figs. 10A to 10F are substantially similar to those of Figs. 9A to 9F in the Making Example 3-1, so description thereto is omitted or simplified.

As shown in Fig. 10A, photosensitive epoxy resin is applied to an upper surface of a lower insulation layer 122 to form an insulation layer 124 of about 20 µm in thickness. Then, as shown in Fig. 10B, the insulation layer 124 is processed by wiring pattern exposure and development to form a side insulation layer 126. Then, as shown in Fig. 10C, the upper surface of the side insulation layer 126 and the surface of the groove 128 are roughened, and surface active agent 130 is attached to the roughened surfaces. Further, as shown in Fig. 10D, catalytic nuclei 132 for plating are attached to the entire surface of the surface active agent 130. Then, as shown in Fig. 10E, on the upper surface of the side insulation layer 126 and the surface of the groove 128 to which the catalytic nuclei 132 for plating have been attached, there is formed an electroless plated layer 134 of about 1 µm in thickness. As shown in Fig. 10F, an electroplated layer 136 of about 10 µm in thickness is formed on the entire surface of the electroless plated layer 134.

As shown in Fig. 10G, etching resist similar to that in the Making Example 3-1 is applied by printing to the recessed portion of the electroplated layer 136 corresponding to the groove 128 and is cured to form the etching resist layer 138.

As shown in 10H, etching is carried out to remove the portions of the electroplated layer 136 and the electroless plated layer 134 on which the etching resist layer 138 is not formed. The etching is performed by a similar technology to that in the above described Making Example 3-1.

As shown in Fig. 10J, the opposite, upward protruded upper end portions of the conductor wiring layer 140 consisting of the electroplated layer 136 and the electroless plated layer 134 and the upper end portion of the side insulation layer 126 are removed by grinding such as tape grinding, buffing, belt grinding or the like until the side insulation layer 126 is ground to the thickness of about 15 µm, whereby to constitute the circuit board 120.

In this manner, in this example, the etching resist layer 138 is formed only in the place or portion where the conductor wiring layer 140 is to be formed, so the quantity of etching resist used can be small, and further the process for removing an unnecessary portion of the etching resist layer 138 (refer to Fig. 10H) can be dispensed with, so there is attained an advantage that the work can be simplified.

In the meantime, the grinding at the step of Fig. 10J can be done so as to remove only the protruded, upper end portions of the conductor wiring layer 140.

In the above described Making Example 3-2, it has been described shown that the etching resist 138 is formed by printing. In place of this, the etching resist 138 can be formed by applying photosensitive etching resist ink to the predetermined place or potion and thereafter processing the applied ink by exposure and development. This makes it possible to obtain a fine patterned, etching resist layer 138.

### (Fourth Embodiment)

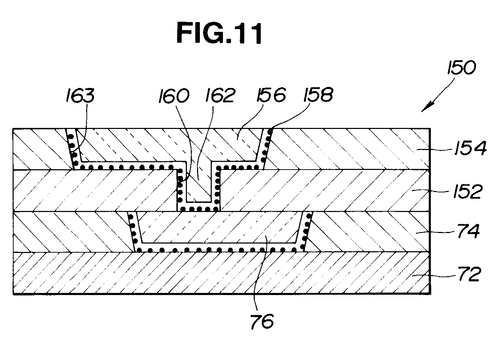

Fig. 11 shows a circuit board 150 according to a fourth embodiment of the present invention.

The circuit board 150 is formed with multi-layered (two stories) conductor wiring layers. The circuit board 150 has an insulation interlayer 152 which is made of adhesive epoxy resin and formed on the entire surface of the side surface layer 74 and the conductor wiring layer 76 of the circuit board 70 as shown in Fig. 8, and further has on the insulation interlayer 152 a side insulation layer 154 made of photosensitive epoxy, resin and a copper conductor wiring layer 156 which are located between adjacent two layer sections of the side insulation layer 154. Pd catalytic nuclei 158 for plating similar to that shown in Fig. 1 are provided at each interface between the conductor wiring layer 156 and the insulation interlayer 152 and at the interface between the conductor wiring layer 156 and the side insulation layer 154.

In the meantime, further on the side insulation layer 154 and the conductor wiring layer 156 there may be formed another insulation interlayer 152 to cover their entire upper surfaces and on the insulation interlayer 152 thus further provided there may be further formed a side insulation layer 154 and a conductor wiring layers 156 which are provided with catalytic nuclei 158 in the above described manner.

By placing the insulation interlayer 152, the side insulation layer 154 and the conductor wiring layer 156 one upon another in the above described order, a multi-layered circuit board having a desired number of stories or laminated wiring layers can be obtained.

Further, the insulation interlayer 152 between the storied or laminated conductor wiring layers 76 and 156 is provided with a through hole 160 at a predetermined place and a via 162 in the through hole 160 for enabling the upper and lower conductor wiring layers 156 and 76 to be conductive to each other. The interface between the side surface or circumferential surface of the via 162 and the insulation interlayer 152 has catalytic nuclei 158 for plating. In the meantime, the through hole 160 can be formed by various technologies, e.g., a technology of forming the through hole 160 by exposure and development of the insulation interlayer 152 made of photosensitive resin, a technology of forming a through hole by irradiation of a laser beam, and the like.

Then, the method of making the circuit board 150 will be descried hereinafter.

The circuit board 150 shown in Fig. 11 can be obtained by the following method. That is, adhesive epoxy resin is applied to the substantially entire upper surfaces of the side insulation layer and the conductor wiring layers of one of the circuit boards 90 and 120 obtained by either of the above described methods of Making Examples 3-1 and 3-2 to form the insulation interlayer 152 having the thickness necessary for insulation, i.e., the thickness ranging from several tens to 100 µm or so. The insulation interlayer 152 is formed with a through hole 160 at a predetermined position. Then, by either of the above described methods, the patterned side insulation layer 154 and the conductor wiring layers 156 which are each disposed between adjacent two layer sections of the side insulation layer 154, are formed on the insulation interlayer 152.

In this connection, at the same time when the upper conductor wiring layer 156 is formed, the through hole 160 of the insulation interlayer 152 is processed by electroless copper plating to form the via 162. That is, catalytic nuclei 158 for plating are attached to the inside of the groove 163 including the through hole 160 and thus having a T-like cross section, so that by electroless plaiting the via 162 can be formed simultaneously with the conductor wiring layer 156. Accordingly, as shown in Fig. 11, the catalytic nuclei 158 exist or are present also at the interface between the side surface (circumferential surface) of the via 162 and the insulation interlayer 152.

In this manner, by repeating the process for obtaining the above described insulation interlayer and the process for obtaining the side insulation layer and the conductor wiring layer between the layer sections thereof according to either of the above described methods a desired number of times, a so-called build-up multi-layer circuit board having three-dimensional wiring.

The present invention is not limited to the above described embodiments but various modifications may be made without departing from the scope of this invention.

For example, the material for forming the substrate constituting the lower insulation layer can be a composite material mainly containing an organic material such as glass-epoxy resin, glass-polyimide resin, paper-epoxy resin and the like, a ceramic material such as alumina, aluminium nitride, glass ceramic and the like, a metal such as aluminum, iron, steel, stainless steel and the like, whose surface is insulated, and a film of resin such as polyimide and the like.

The photosensitive resin for forming the above described insulation layer can be, other than the above described one, phenol novolak resin added with diazotype sensitive material, dry film photoresist, or the like. Further, the exposure rays can be visible rays, far infrared rays, electron beam or radiant rays such as X rays.

From the foregoing, it will be understood that in the circuit board of this invention there does not exist any catalytic nucleus for plating at the interface between the lower insulation layer (substrate) and the side insulation layer, so there never occurs migration between the conductor wiring layers and therefore a short circuit therebetween. Further, there exist catalytic nuclei for plating at the interface between the conductor wiring layer and the lower insulation layer, so there are never caused any plating defect and any missing part of the conductor wiring layer. Accordingly, it becomes possible to improve the insulation between the conductor wiring layers while enabling the side insulation layer located between the conductor wiring layers to become as small in width as possible, e.g. to be 30 µm or so wide, thus making it possible to attain a high density wiring.

Further, since there exist catalytic nuclei for plating at the interface between the side insulation layer and the conductor wiring layer, the adherence between them can be improved and there is not caused any space between them, thus making it possible to prevent plating solution residual otherwise caused in the prior art device, a stain and deterioration of the insulation caused by such residual, and a crack or cracks extending inside the lower insulation layer. Accordingly, it becomes possible to provide a circuit board which is high in the wiring density and reliable in operation for an elongated period of life.

Further, By the method of the present invention, it becomes possible to obtain a circuit board of the foregoing character with substantially the same number of process steps and with accuracy and assuredness, without requiring particular materials, chemicals, treatments, etc., thus making it possible to provide the circuit board with low cost and with stability.

Further, when the conductor wiring layer is constructed so as to include, other than the electroless plated layer, the electroplated layer, it can be high in the wiring density and can have excellent physical properties (ductility, tensile strength, conductivity, etc.).

## Claims

1. A circuit board comprising:
a lower insulation layer;
a side insulation layer formed on an upper surface of said lower insulation layer and having a pair of layer sections;
a conductor wiring layer formed on the upper surface of said lower insulation layer and having opposite side surfaces in contact with said layer sections of said side insulation layer, respectively;
wherein catalytic nuclei for plating are provided to an interface between a bottom surface of said conductor wiring layer and the upper surface of said lower insulation layer and to an interface between each of said side surfaces of said conductor wiring layer and a corresponding side surface of each of said layer sections of said side insulation layer.

2. The circuit board according to claim 1, wherein said lower insulation layer has a via at a location just under said conductor wiring layer, and catalytic nuclei for plating are provided to an interface between a side surface of said via and said lower insulation layer.

3. The circuit board according to claim 1, wherein said conductor wiring layer comprises an electroless plated layer located on a bottom surface side thereof and an electroplated layer formed on said electroless plated layer.

4. A method of making a circuit board comprising the steps of:
forming a side insulation layer having a pair of layer sections, on an upper surface of a lower insulation layer and forming a groom of a predetermined pattern defined by side surfaces of said layer sections of said side insulation layer and said upper surface of said lower insulation layer;
attaching catalytic nuclei for plating to at least said side surfaces of said layer sections of said side insulation layer and a portion of said upper surface of said lower insulation layer exposed to said groove; and
electroless plating an inside of said groove and forming a conductor wiring layer within said groove.

5. The method according to claim 4, wherein the step of said forming said side insulation layer comprises a step of applying a photosensitive resin to said upper surface of said lower insulation layer and drying the same to form a photosensitive resin layer, and a step of subjecting said photosensitive resin layer to exposure and development to form said side insulation layer and said groove of said predetermined pattern.

6. The method according to claim 4, further comprising, after the step of said attaching said catalytic nuclei for plating, a step of removing an upper end portion of said side insulation layer by grinding.

7. The method according to claim 4, wherein the step of said forming said conductor wiring layer comprises a first plating step of carrying out said electroless plating until a plated layer of a predetermined thickness is obtained, a step of removing by grinding a portion of said plated layer deposited on an upper surface of said side insulation layer and further removing by grinding an upper end portion of said side insulation layer, and a second plating step of thereafter electroless plating the inside of said groove once again and forming said conductor wiring layer.

8. The method according to claim 4, further comprising, after the step of said forming said side insulation layer, a step of forming a thin water repellent resin layer on an upper surface of said side insulation layer.

9. The method according to claim 5, wherein said photosensitive resin forms at a surface thereof a thin water repellent resin layer when dried.

10. The method according to claim 5, wherein the step of said forming said insulation layer comprises, before said exposure of said photosensitive resin layer or after said exposure but before said development of same, a step of applying an anion surface active agent to an upper surface of said side insulation layer.

11. The method according to claim 4, further comprising, after the step of said forming said conductor wiring layer, a step of removing an upper end portion of said conductor wiring layer and an upper end portion of said side insulation layer by grinding and making said conductor wiring layer and said side insulation layer have a predetermined, uniform thickness.

12. The method according to claim 4, wherein the step of said forming said conductor wiring layer comprises a step of conducting said electroless plating to form a conductor layer of a predetermined thickness on an upper surface of said side insulation layer as well as said side surfaces of said layer sections of said side insulation layer and said upper surface portion of said lower insulation layer exposed to said groove, a step of forming an etching resist layer on an upper surface portion of said conductor layer above said groove, and a step of thereafter conducting etching and removing all of said conductor layer except for a portion thereof on which said etching resist layer is formed.

13. The method according to claim 12, when the step of said forming said etching resist layer comprises a step of forming an etching resist film on an upper surface of said conductor layer, and a step of removing by grinding said etching resist film except for a portion thereof above said groove until a portion of said conductor layer located above said side insulation layer is exposed.

14. The method according to claim 12, wherein the step of said forming said etching resist layer comprises a step of forming an etching resist film on said conductor layer, and a step of removing by resin etching said etching resist film except for a portion thereof above said groove until at least a portion of said conductor layer located above said side insulation layer is exposed.

15. The method according to claim 12, wherein the step of said forming said etching resist layer comprises a step of printing an etching resist film on said upper surface portion of said conductor layer above said groove and curing the same.

16. The method according to claim 12, wherein the step of said forming said etching resist layer comprises a step of applying a photosensitive etching resist film to said upper surface of said conductor layer, and a step of removing said photosensitive etching resist film except for a portion thereof above said groove by exposure and development and making at least a portion of said conductor layer located above said side insulation layer be exposed.

17. The method according to 12, further comprising, after the step of said removing said etching resist layer, a step of grinding at least upper end portions of said conductor layer which remain unremoved at the step of said removing said conductor layer and making surface arrangement of same.

18. The method according to claim 17, wherein the step of said making said surface arrangement further comprises a step of grinding said upper surface of said side insulation layer and making surface arrangement of same.

19. A method of making a circuit board comprising the steps of:
forming a side insulation layer having a pair of layer sections, on an upper surface of a lower insulation layer and forming a groove of a predetermined pattern defined by side surfaces of said layer sections of said side insulation layer and said upper surface of said lower insulation layer;
attaching catalytic nuclei for plating to an upper surface of said side insulation layer, said side surfaces of said layer sections of said side insulation layer and a portion of said upper surface of said lower insulation layer exposed to said groove;
electroless plating said upper surface of said side insulation layer and an inside of said groove and forming an electroless plated layer thereon; and
electroplating said electroless plating layer and forming an electroplated layer thereon.

20. The method according to claim 19, wherein the step of said forming said side insulation layer comprises a step of applying a photosensitive resin to said upper surface of said lower insulation layer and drying the same to form a photosensitive resin layer thereon, and a step of subjecting said photosensitive resin layer to exposure and development to form said side insulation layer and said groove of said predetermined pattern.

21. The method according to 19, further comprising, after forming a conductor layer consisting of said electroless plated layer and said electroplated layer, a step of forming an etching resist layer on an upper surface portion of said conductor layer above said groove, and a step of thereafter carrying out etching and removing all of said conductor layer except for a portion thereof on which said etching resist layer is formed.

22. The method according to claim 19, wherein the step of said forming said etching resist layer comprises a step of forming an etching resist film on an upper surface of said conductor layer, and a step of removing by grinding said etching resist film except for a portion thereof above said groove until at least a portion of said conductor layer located above said side insulation layer is exposed.

23. The method according to claim 19, wherein the step of said forming said etching resist layer comprises a step of forming an etching resist film on said conductor layer, and a step of removing by resin etching said etching resist film except for a portion thereof above said groove until at least a portion of said conductor layer located above said side insulation layer is exposed.

24. The method according to claim 19, wherein the step of said forming said etching resist layer comprises a step of printing an etching resist film said upper surface portion of said conductor layer above said groove and curing the same.

25. The method according to claim 19, wherein the step of said forming said etching resist layer comprises a step of applying a photosensitive etching resist film to said upper surface of said conductor layer, and a step of removing said photosensitive etching resist film except for a portion thereof above said groove by exposure and development and making at least a portion of said conductor layer located above said side insulation layer be exposed.

26. The method according to 19, further comprising, after the step of said removing said etching resist layer, a step of grinding at least upper end portions of said conductor layer which remain unremoved at the step of said removing said conductor layer and making surface arrangement of same.

27. The method according to claim 26, wherein the step of said making said surface arrangement further comprises a step of grinding said upper surface of said side insulation layer and making surface arrangement of same.
